**Europäisches Patentamt**

**European Patent Office**

**Office européen des brevets**

(19)

(11). Veröffentlichungsnummer : **0 026 824 B2**

# NEUE EUROPÄISCHE PATENTSCHRIFT

(12)

(45) Veröffentlichungstag der neuen Patentschrift :
20.03.91 Patentblatt 91/12

(51) Int. Cl.⁵ : **G01R 1/073, G01R 31/28, H05K 13/08**

(21) Anmeldenummer : **80104687.1**

(22) Anmeldetag : **08.08.80**

(54) **Adapter für eine Vorrichtung zur elektronischen Prüfung von Leiterplatten.**

Die Akte enthält technische Angaben, die nach dem Eingang der Anmeldung eingereicht wurden und die nicht in dieser Patentschrift enthalten sind.

(30) Priorität : **21.08.79 DE 2933862**

(43) Veröffentlichungstag der Anmeldung :
**15.04.81 Patentblatt 81/15**

(45) Bekanntmachung des Hinweises auf die
Patenterteilung :
**17.07.85 Patentblatt 85/29**

(45) Bekanntmachung des Hinweises auf die
Entscheidung über den Einspruch :
**20.03.91 Patentblatt 91/12**

(84) Benannte Vertragsstaaten :
**BE CH FR GB LI NL**

(56) Entgegenhaltungen :
DE-A- 1 800 657
DE-A- 2 063 198
DE-A- 2 839 982
DE-B- 2 243 457
DE-B- 2 427 118
DE-B- 2 707 900
DE-U- 7 031 416

(56) Entgegenhaltungen :
GB-A- 720 908
US-A- 3 016 489
US-A- 3 564 408
US-A- 3 996 516
IBM TECHNICAL DISCLOSURE BULLETIN,
Vol. 17, No. 2, July 1974 New York U. RENZ
"Multipoint Test Probe for Printed Cards",
Seiten 459-460

(73) Patentinhaber : **Mang, Paul
Weilbergstrasse 4
W-6384 Schmitten 3 (DE)**
Patentinhaber : **MANIA Elektronik
Automatisation Entwicklung und Gerätebau
GmbH
Hauptstrasse 86
W-6384 Schmitten 2 (DE)**

(72) Erfinder : **Mang, Paul
Weilbergstrasse 4
W-6384 Schmitten 3 (DE)**
Erfinder : **Nimmerrichter, Günther
Thüringer Strasse 3
W-6384 Schmitten 1 (DE)**

(74) Vertreter : **Ruschke, Hans Edvard et al
Patentanwälte Dipl.-Ing. Olaf Ruschke
Dipl.-Ing. Hans E. Ruschke Dipl.-Ing. Jürgen
Rost Dipl.-Chem. Dr. U. Rotter
Pienzenauerstrasse 2
W-8000 München 80 (DE)**

EP 0 026 824 B2

**Beschreibung**

Die Erfindung betrifft einen Adapter zur Anpassung der Kontaktfiguration einer elektronischen Prüfvorrichtung für Leiterplatten an die Konfiguration der Anschlußpunkte auf einer zu prüfenden Leiterplatte gemäß dem Oberbegriff des Anspruchs 1.

Es ist bereits bekannt, Leiterplatten elektronisch zu prüfen, um ein zuverlässiges Ergebnis über die Funktionstüchtigkeit einer Leiterplatte zu erhalten. Bei einer leiterplatte mit 1000 Anschlußbohrungen sind zur zuverlässigen Prüfung eine halbe Million Prüfungen auf Zweipunktverbindungen nötig, so daß nur die Anwendung elektronischer Prüfverfahren eine wirtschaftliche Prüfung in vertretbarer Zeit erlaubt.

Es is bereits eine Prüfvorrichtung bekannt, die durch eine einwandfreie, in die Aufnahme für die Leiterplatte eingelegte Leiterplatte programmiert wird, wobei alle möglichen Kombinationen der Zweipunktverbindungen in das Programm aufgenommen und jede Verdingung auf der Leiterplatte gespeichert wird. Werden anschließend identische Leiterplatten zur Prüfung in die Vorrichtung eingebracht, so findet ein Vergleich jeder einselnen Zweipunktprüfung mit der Speicherinformation statt, wobei bei fehlender identität zwischen der gemessenen und der gespeicherten Information eine Fehleranzeige und gegebenenfalls eine Aussortierung der fehlerhaften Leiterplatte stattfindet.

Die Prüfvorrichtung benötigt für jeden Anschlußpunkt der Leiterplatte einen Prüfkontakt, wobei die Konfiguration einen Prüfkontakt der Konfiguration der zu überprüfenden Anschlußpunkte entsprechen muß. Zu diesem Zweck wird die bekannte Prüfvorrichtung mit einem Adapter verbunden, der die Prüfkontakte in einer Konfiguration aufweist, die der Konfiguration der Anschlußpunkte an der zu prüfenden Leiterplatte entspricht. Sobald mit der Vorrichtung die Prüfung der Anschlußpunkte durchgeführt werden soll, muß der Adapter ausgewechselt werden.

In den Adaptern sind die Prüfkontakte in Form von Kontaktstiften ausgebildet, die einzeln federnd gelagert sind, so daß eine sichere Kontaktgabe zwischen den einzelnen Anschlußpunkten der Leiterplatte und den zugeordneten kontaktstiften gewährleistet ist, wenn die jeweils in der Aufnahme befindliche Leiterplatte gegen die Kontaktstifte gedrückt wird. Die Kontaktstifte selbst sind über ein am Adapter angebrachtes Verbindungskabel und mindestens einen Vielfachstecker mit der Prüfschaltung verbunden. Ein derartiger Adapter ist etwa aus der US-A-3 564 408 bekannt, wobei die Kontaktstifte in den entsprechen den Anschlußpunkten der zu prüfenden Leiterplatte angeordneten Bohrungen einer Führungsplatine gehltert sind.

Die DE-B2-2 707 900 oder die DE-A-1 800 657 zeigen einen rastergebunden, fest verdrahteten Adapter, der Vollständig mit in einem Führungsteil angeordneten, axial verschieblichen Kontaktstiften versehen ist, die an den den Anschlußpunkten der zu prüfenden Leiterplatte entsprechenden Stellen vorgeschoben sind, so daß nur diese Kontaktstifte aktiviert sind, d.h. die zu prüfender Leiterplatte kontaktieren.

Die Herstellung dieser Adapter erfordert hohe Präzision und ist verhältnismäßig kostspielig. Wegen der hohen Herstellungskosten der Adapter ist es besonders unwirtschaftlich, daß jeder Adapter nur zur Prüfung einer bestimmten Leiterplattentype oder eines bestimmten Anschlußpunktrasters geeignet ist und daß der Adapter praktisch wertlos ist, wenn diese Leiterplattentype oder ein solches Raster nicht gefertigt wird und deshalb nicht mehr geprüft werden muß.

In dem gattungsbildenden Adapter nach dem DE-U-7 031 416 erstrecken sich nadelförmige Kontaktstifte durchgehend von den nach einem festen Raster angeordneten Prüfkontakten der Prüfvorrichtung zu den nach einem anderen Raster oder beliebig angeordneten Anschlußpunkten der Leiterplatte. Die Kontaktstifte werden dabei von zwei voneinander beabstandeten Isolierstoffplatten gehalten, von denen die eine Bohrungen entsprechend dem Raster der Prüfkontakte und die andere Bohrungen entsprechend der Anordnung der Anschlußpunkte der zu prüfenden Leiterplatte aufweist. Dies bedeutet, daß die Kontaktstifte zum Ausgleich von eventuellen Fluchtungsdifferenzen im Raum zwischen den Anschlußpunkten und Prüfkontakten zumindest teilweise schräg zueinander verlaufen. Diese schräge Anordnung der Kontaktstifte kann dazu führen, daß die Kontaktstiftspitzen nicht genau auf die vorgesehenen Anschlußpunkte der gedruckten Leiterplatte auftreffen, was zu Kontaktfehlern und somit zu erheblichen Zeitverlusten bei der Einrichtung eines solchen Adapters führen kann. Die eine der zu prüfenden Leiterplatte zugewandte, die Kontaktstifte führende Isolierstoffplatte (Führungsplatine) ist zwar durch sogenanntes Abbohren von einem Muster der zu prüfenden Leiterplatte hergestellt worden, doch verlaufen die nadelartigen Kontaktstifte auch über diese Führungsplatine in Richtung auf die zu prüfende Leiterplatte hinaus in schräger Richtung, so daß je nach dem Abstand der Führungsplatine von der Leiterplatte und der mehr zufälligen Schräglage der nadelartigen Kontaktstifte in der Ebene der Leiterplatte eine mehr oder weniger große Abweichung der Spitzen der Konaktstifte von der vorgesehenen Soll-Lage, d.h. von den Anschlußpunkten der Leiterplatte zu erwarten ist. Dies hat zur Folge, daß ein unnötiger Unsicherheitsfaktor in das Prüfergebnis der Leiterplatten eingeführt wird, da je nach dem Maß der Abweichung der Kontaktstifte von dem zugeordneten Anschlußpunkt eine mehr oder weniger schlechte Kontaktierung erfolgen wird, was zu unsystematisch auftretenden Fehlern bei der Prüfung von Leiterplatten und somit zu einem verschlechterten und unwirtschaftlichen Prüfergebnis führt.

Der Erfindung liegt die Aufgabe zugrunde, einen Adapter so auszubilden, daß der Aufwand für die Anpassung an unterschiedliche Typen zu prüfender Leiterplatten mit wesentlich geringeren Kosten und wesentlich höherer Wirtschaftlichkeit möglich ist als bisher. Insbesondere soll neben einer spürbaren Senkung der Kosten auch eine wesentliche Herabstzung der benötigten Arbeitszeit für die Anpassung an eine bestimmte Leiterplatte erreicht werden.

Scließlich ist es auch noch eine Aufgabe der Erfindung, einen Adapter so auszugestalten, daß die Anpassung an eine bestimmte Konfiguration der Anschlußpunkte auf der leiterplatte ohne besondere Werkzeuge oder Spezialkenntnisse möglich ist.

Die Lösung ist bei einem Adapter des eingangs genannter Art durch die Kennrichwerden Maßnahmen gemäß Anspruch 1 gegeben.

Diese Lösung ermöglicht die rasche, einfache und preisgünstige Anpassung an die jeweilige Konfiguration der Anschlußpunkte auf der Leiterplatte. Es ist lediglich erforderlich, die Führungsplatinen in an sich bekannter Weise deckungsgleich mit den Anschlußbohrungen an der Leiterplatte zu bohren und durch die so erzeugten Führungskanäle der Führungsplatinen die nadelartigen Kontaktstifte einzustecken, bis das gegen die Grundplatte weisende Ende eines jeden Kontaktstifts in einen Führungskanal der Grundplatte eingedrungen ist. Es ist dabei keineswegs erforderlich, daß die Anschlußpunkte der Leiterplatte entsprechend dem in der Grundplatte vorgesehenen Raster der Führungskanäle verteilt sind, weil durch die nadelartige Gestaltung der Kontaktstifte einerseits und durch die dichte Anordnung des Rasters in der Grundplatte andererseits die Kontaktstifte soweit aus ihrer Führungsrichtung ausgelenkt werden Können, daß sie in einen der Führungskanäle der Grundplatte eingreifen. Es ist dabei außerdem ohne Bedeutung, in welchen Führungskanal der Grundplatte jeder Kontaktstift eingreift, weil einerseits durch entsprechende Anpassung des Querschnitts der Führungskanäle an den Querschnitt der Kontaktstifte sichergestellt werden kann, daß in jeden Führungskanal nur ein Kontaktstift eingreift und weil andererseits die Programmierung der Prüfschaltung in Abhängigkeit von einer einwandfreien Leiterplatte erfolgt, so daß die entsprechenden Speicherinformationen demjenigen Kontakt zugeordnet werden, der durch einen Prüfstift besetzt ist. Wird der Adapter in der vorbereiteten Konfiguration der Prüfkontakte nicht mehr benötigt, können die Führungsplatinen durch Führungsplatinen mit anderer Konfiguration der Führungskanäle ersetzt werden, wobei die Prüfstifte neu verteilt werden, so daß der Aufwand zur Herstellung eines neuen Adapters relativ gering ist.

Diese Ausbildung ermöglicht es, einen durch entsprechende Führungsplatinen und entsprechende Anordnung der Kontaktsstifte für die Prüfung einer bestimmten Leiterplattentype vorbereiteten Adapter nach Prüfung der entsprechenden Leiterplatten als geschlossenes Bauelement von der Vorrichtung abzunehmen und durch einen für die Prüfung einer anderen Leiterplattentype vorbereiteten Adapter gleicher Bauart zu ersetzen, so daß unter Verwendung der besanders einfach und preisgünstig herzustellenden Adapter eine rasche Umrüstung der Vorrichtung auf unterschiedliche Leiterplattentypen möglich ist. Insbesondere entfällt durch diese Konstruktion die vielfach übliche Verbindung des Adapters mit der Prüfschaltung über Kabel und Vielfachstecker, weil die Verbindung der Prüfkontakte mit der Prüfschaltung dadurch erfolgt, daß die in die Führungskanäle der Grundplatte eingreifenden Kontaktstifte beim Aufsetzen des Adapters auf die Prüfvorrichtung mit der Kontaktkonfiguration der Prüfvorrichtung in Eingriff kommt.

Der erfindungsgemäße Adapter ist weder rastergebunden noch fest verdrahtet und wird aus auslenkbaren wiederverwendbaren Kontaktstiften aufgebaut. Der Adapter ist insgesamt als komplette separate Einheit von der Prüfvorrichtung abnehmbar gestaltet und somit besonders einfach zu handhaben.

Weitere vorteilhafte Ausgestaltungen der Erfindung ergeben sich aus den Unteransprüchen in Verbindung mit der nachfolgenden Beschreibung.

Anhand der nun folgenden Beschreibung eines in der Zeichnung dargestellten Ausführungsbeispiel der Erfindung wird diese näher erläutert.

Es zeigt :

Figur 1 einen Vertikalschnitt durch Anschlußplatte und Adapter in etwa natürlicher Größe ;

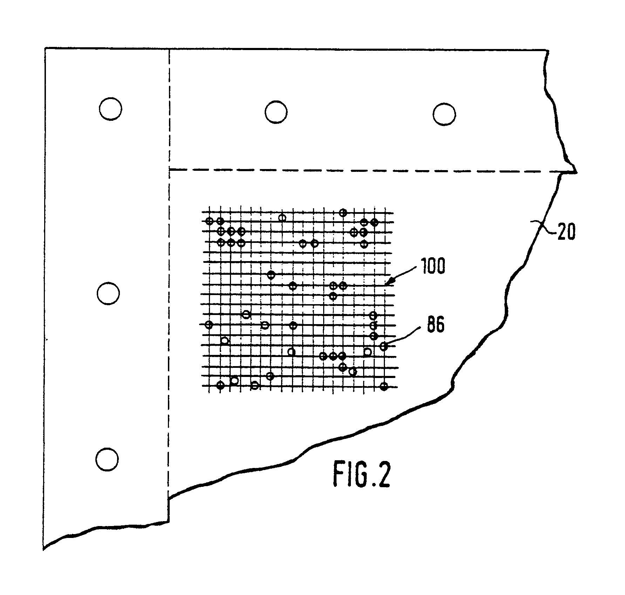

Figur 2 eine Draufsicht auf einen Ausschnitt der Grundplatte mit der Projektion von Führungsbohrungen der Führungsplatinen ; und

Figur 3 einen der Fig. 1 entsprechenden Schnitt in vergrößertem Maßstab.

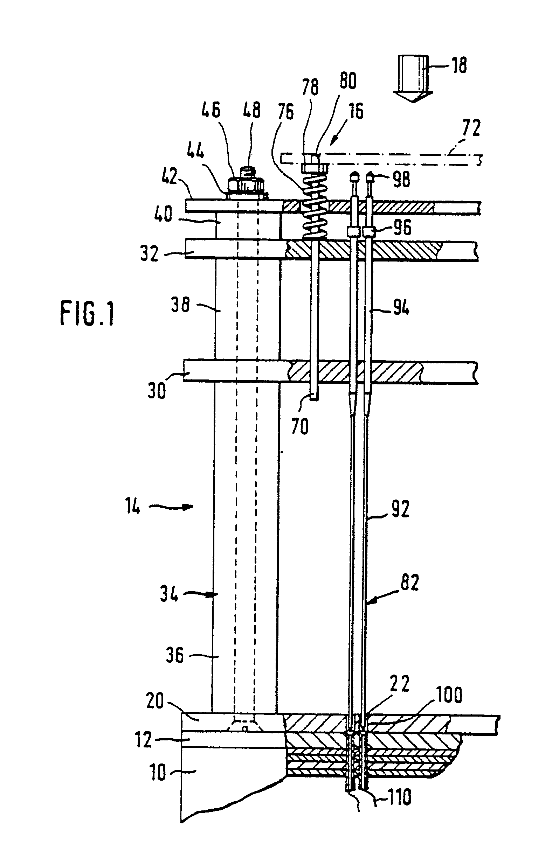

In Fig. 1 ist mit 10 ein durch ein Gehäuse verkleideter Sockel der gesamten Prüfvorrichtung bezeichnet, der in seinem Inneren die für die Programmierung, Speicherung, bzw. Prüfung erforderlichen elektronischen Einrichtungen enthält und an dessen Außenseite die erforderlichen Schalt- und Anzeigeelemente vorgesehen sind. Diese Einrichtungen sind im wesentlichen bekannt und nicht Gegenstand der vorliegenden Erfindung, sie werden deshalb nicht näher dargestellt.

Auf dem Sockel 10 ist eine Anschlußplatte 12 angebracht, in deren Bereich die für die Prüfung der jeweils zu prüfenden Leiterplatte erforderlichen Prüfkontakte mit der im Inneren des Sockels 10 befindlichen elektronischen Einrichtungen verbunden werden.

Ein zur Anpassung an die jeweils zu prüfenden Leiterplatte bestimmter Adapter ist insgesamt mit 14 bezeichnet und abnehmbar am Sockel 10 befestigt.

Die zu prüfenden Leiterplatten werden auf eine am Adapter 14 ausgebildete Auflage 16 aufgelegt und dann mittels einer lediglich schematisch angedeuteten Andrückvorrichtung 18 entgegen einer Rückstellkraft gegen die Prüfkontakte am Adapter 14 gedrückt. Diese Andrückvorrichtung 18 kann beispielsweise ein durch ein Strömungsmittel betätigbarer Zylinder sein.

Die Zufuhr der zu prüfenden Leiterplatten in den Bereich des Adapters 14 kann entweder von Hand erfolgen, oder zweckmäßigerweise aus einem Vorratsmagazin, wobei dann zweckmäßigerweise auch eine Vorrichtung zur Weiterleitung der geprüften Leiterplatten vorgesehen sein kann, welche zweckmäßigerweise noch mit einer Sortiereinrichtung zur Sortierung der Leiterplatten je nach dem Prüfergebnis ausgestattet sein kann. Diese Vorrichtungen zur Zuführung bzw. Abführung der Leiterplatten unterscheiden sich nicht von bereits bekannten Einrichtungen dieser Art, so daß sie in der Zeichnung zur Verbesserung der Übersichtlichkeit nicht dargestellt sind.

Der Adapter 14 besteht aus einer Grundplatte 20, die in einem dichten Raster mit Führungsbohrungen 22 versehen ist, die rechtwinklig zur Ebene der Grundplatte 20 verlaufen und in welche ein Führungseinsatz 24 eingesetzt ist, dessen zylindrische Bohrung sich nach der Oberseite der Grundplatte 20 bei 28 konisch erweitert.

Für die Funktion des Adapters 14 sind außer der Grundplatte 20 noch zwei Führungsplatinen 30 und 32 erforderlich, welche mit einem gewissen Abstand von der Grundplatte 20 parallel zu dieser angeordnet sind. Dabei ist, wie deutlich aus Fig. 1 ersichtlich ist, der Abstand zwischen der der Grundplatte 20 benachbarten Führungsplatine 30 wesentlich größer als der Abstand zwischen den beiden Führungsplatinen 30 und 32.

Um die Grundplatte 20 und die Führungsplatinen 30 und 32 in dem erforderlichen Abstand parallel zueinander und zueinander genau ausgerichtet zu halten, dienen allgemein mit 34 bezeichnete Säulen, die zumindest an den vier Ecken der Grundplatte 20 angeordnet sind und die aus jeweils einem Distanzstück 36 zwischen der Grundplatte 20 und der Führungsplatine 30 und einem Distanzstück 38 zwischen den beiden Platinen 30 und 32, sowie gegebenenfalls einem weiteren Distanzstück 40 zwischen der Führungsplatine 32 und einer gegebenenfalls noch vorhandenen Sicherungsplatine 42 und einer mit einer Unterlegscheibe 44 und einer Spannmutter 46 versehenen Spannschraube 48 bestehen. Für den Durchtritt der Spannschrauben 48 sind die Grundplatte 20, die Führungsplatinen 30 und 32 und die gegebenenfalls vorhandene Sicherungsplatine 42 mit Bohrungen 50, 52, 54 und 56 versehen. Die in der Grundplatte 20 ausgebildeten Bohrungen 50 sind an der Unterseite der Grundplatte 20 mit Ansenkungen 58 versehen, in welchen ein Senkkopf 60 der jeweils zugeordneten Spannschraube 48 derart untergebracht ist, daß er nicht über die Unterseite 62 der Grundplatte nach unten vorsteht.

Durch Lösen der Spannmuttern 46 ist es jederzeit möglich, die Führungsplatinen 30 und 32 und gegebenenfalls die Sicherungsplatine 42 auszuwechseln, wie dies aus später noch erläuterten Gründen zur Anpassung des Adapters 14 an eine bestimmte Leiternplattentype erforderlich ist.

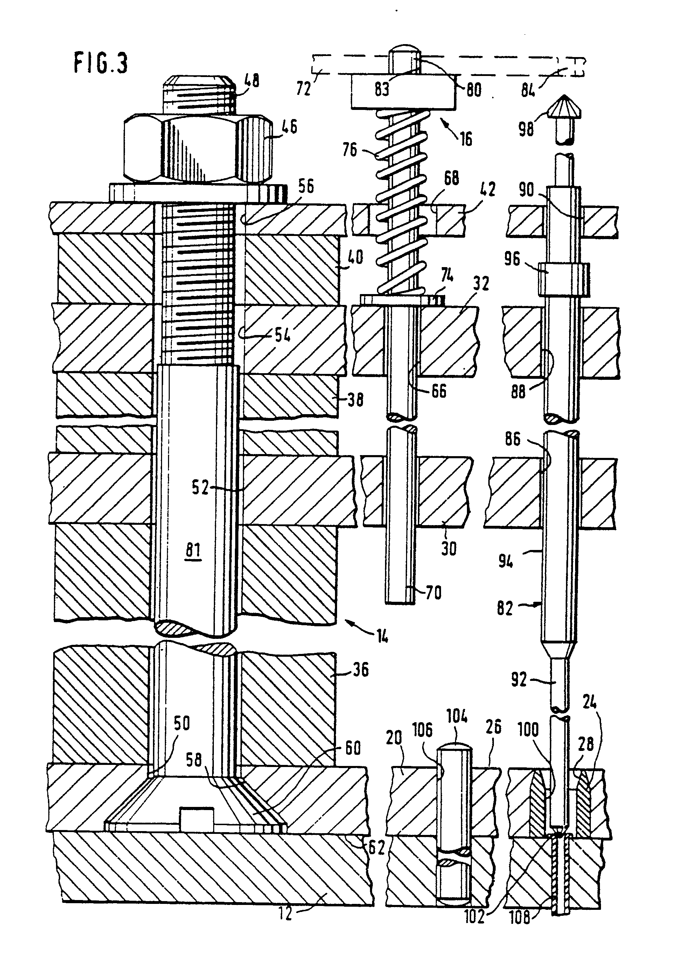

Die Führungsplatinen 30 und 32 und gegebenenfalls die Sicherungsplatine 42 weisen zweckmäßigerweise in der Nähe der Eckbereiche koaxiale Bohrungen 64, 66 und 68 auf, die für die Anordnung bzw. Lagerung eines Auflagerzapfens 70 erforderlich sind. Die beispielsweise in den Eckbereichen der Platinen 30, 32 und gegebenenfalls 42 angeordneten Auflagerzapfen 70 bilden insgesamt ein Auflager für die zu prüfende Leiterplatte, welche in Fig. 3 schematisch in strichpunktierten Linien angedeutet und mit 72 bezeichnet ist.

Der Auflagerzapfen 70 ist im wesentlichen als zylindrischer Stab ausgebildet und ragt mit seinem unteren Ende durch die ihm im Querschnitt angepaßten Bohrungen 64 und 66 in den Führungsplatinen 30 bzw. 32, so daß er in vertikaler Richtung beweglich geführt ist. Auf der Oberseite der Führungsplatine 32 liegt eine Scheibe 74 auf, gegen welche sich eine den Auflagerzapfen oberhalb der oberen Führungsplatine 32 umschließende Druckfeder 76 abstützt. Das obere Ende der Druckfeder 76 liegt an einem Bund 78 an, der beispielsweise durch einen mit dem Auflagerzapfen 70 axial unverschieblich verbundenen Ring gebildet wird. Der Bund bzw. Ring 78 ist derart auf dem Auflagerzapfen 70 angeordnet, daß dieser noch nach ober über den Bund bzw Ring so ausreichend übersteht, daß ein Positionierungsabschnitt 80 gebildet wird, der in eine entsprechende Positionierungsbohrung 83 an der Leiterplatte 72 eingreifen kann. Dadurch wird die Leiterplatte beim Auflegen auf das durch die Auflagerzapfen 70 gebildete Auflager genau gegenüber der Grundplatte 20 und den Führungsplatinen 30 und 32 positioniert

Um die Druckfeder 76 nicht zu behindern, ist die Bohrung 68 in der gegebenenfalls vorhandenen Sicherungsplatine gegenüber dem Durchmesser der Bohrurgen 64 und 66 in den Führungsplatinen 30 und 32 ausreichend erweitert.

Die genaue Positionierung der Führungsplatinen 30 und 32 gegenüber der Grundplatte 20 erfolgt durch den zylindrischen Schaft 81 der Spannschraube 48, der mit den Bohrungen 52 bzw. 54 zusammenwirkt.

Zur Aufnahme von nachstehend noch näher erläuterten Kontaktstiften 82 werden die Führungsplatinen 30 und 32, sowie gegebenenfalls die Sicherungplatine 42 genau gegenüber einer als Muster dienenden Leiterplatte 72 des zu prüfenden Typs ausgerichtet, worauf dann die Platinen deckungsgleich mit den Anschlußbohrungen 84 der Leiterplatte 72 Bohrungen 86, 88 und 90 erhalten, von welchen die Bohrungen 86 und 88 in den Führungsplatinen 30 und 32 als Führungsbohrungen für die Kontaktstifte 82 dienen.

Die mit den Führungsbohrungen 86 und 88 versehenen Führungsplatinen 30 und 32 werden zunächst durch die Distanzstücke 36 und 38 und die Spannschraube 58, sowie die Spannmutter 46 an der Grundplatte 20 genau positioniert befestigt.

Anschließend wird durch jedes deckungsgleiche Paar von Führungsbohrungen 86 und 88 jeweils von oben her ein nadelförmiger Kontaktstift 82 eingeführt. Die unteren, sich zwischen der Führungsplatine 30 und der Grundplatte 20 erstreckenden Abschnitte 92 der Kontaktstifte 82 sind verhältnismäßig dünn und nadelförmig ausgebildet, während der obere, die Führungsplatinen 30 und 32 und gegebenenfalls noch die Sicherungsplatine 42 durchquerende Abschnitt 94 der Kontaktstifte 82 demgegenüber verstärkt und biegesteifer ist. Dieser verstärkte Abschnitt 94 trägt nahe seinem oberen Ende einen Bund 96, der die axiale Bewegung des Kontaktstifts 82 nach unten durch Anschlag an der Oberseite der Führungsplatine 32 begrenzen kann.

Wird nun nach dem Einsetzen der Kontaktstifte 82 in die Führungsplatinen 30 und 32 abschließend die Sicherungsplatine 42 aufgesetzt, so begrenzt die Sicherungsplatine 42 die Bewegung der Kontaktstifte 82 nach oben, weil der Bund 98 sich gegen die Unterseite der Sicherungsplatine 42 legt. Am oberen Ende der Kontaktstifte 82 ist schließlich eine Kantaktspitze 98 vorgesehen, die entgegen der Wirkung einer nicht gezeigten Rückstellfeder etwas in Richtung auf den verstärkten Abschnitt 94 gedrückt werden kann.

Durch die deckungsgleichen Führungsbohrungen 86 und 88 in den Führungsplatiner 30 und 32 werden die eingesetzten Kontaktstifte 82 jeweils genau rechtwinklig zur Ebene dieser Führungsplatinen 30 und 32 und zur Ebene der Grundplatte 20 ausgerichtet und in dieser zur Oberfläche der Grundplatte 20 rechtwinkligen Richtung sind die Kontaktstifte 82 beweglich geführt. Da die Führungsbohrungen 86 und 88 deckungsgleich mit den Anschlußbohrungen 84 der Leiterplatte 72 gebohrt worden sind, sind die Kontaktspitzen 98 nach dem Positionieren einer Leiterplatte 72 auf den Auflagerzapfen 70 genau gegen diese Anschlußbohrungen 84 ausgerichtet.

Die Anschlußbohrungen 84 ihrerseits sind auf der Leiterplatte nach dem jeweiligen Erfordernissen des Leiterbildes bzw. der vorgesehenen Bestückung der Leiterplatte verteilt, so daß die Konfiguration dieser Anschlußbohrungen 84 nicht dem Raster der Führungsbohrungen 22 bzw. der in den Führungseinsätzen 24 befindlichen Führungskanäle 100 entspricht. Die durch die Führungsbohrungen 86 und 88 der Führungsplatinen 30 und 32 eingeführten Kontaktstifte 82 werden also mit den unteren Enden ihrer nadelförmigen Abschnitte 92 nicht in jedem Fall genau gegenüber einem Führungskanal 100 ausgerichtet sein. Wegen der konischen Erweiterungen 28 am oberen Ende der Führungskanäle 100 wird aber in den meisten derartigen Fällen das untere Ende der Kontaktstifte 82 ohne weitere Maßnahmen etwas elastisch ausgelenkt und in einen geeigneten Führungskanal 100 eingeführt werden. Sofern dies in eimen wenigen Fällen nicht zutreffen sollte, genügt es, beim Bestücken des Adapters 14 mit den Kontaktstiften 82 den nadelförmigen Abschnitt 92 etwas durch manuelle Einwirkung auszulenken, bis der nadelförmige Abschnitt 92 durch den in axialer Richtung ausgeübten Einführdruck in einen geeigneten Führungskanal 100 eindringt. Wenn alle Führungsbohrungen 86 und 88 mit Kontaktstiften 82 bestückt sind, ist der Adapter 14 betriebsbereit. In diesem Zustand liegen die unteren, als Kontaktspitzen 132 ausgebildeten Enden der Kontaktstifte 82 nahe der unteren Oberfläche 62 der Grundplatte 20 geschützt innerhalb der Führungskanäle 100.

Der Adapter 14 kann nun auf die am Sockel 10 angeordnete Anschlußplatte 12 aufgesetzt werden, und zwar in einer genau positionierten Lage, welche durch mindestens zwei in die Anschlußplatte 12 eingesetzte, aus dieser nach oben vorstehende Positionierungsstifte 104 gewährleistet wird, denen an der Grundplatte 20 entsprechende Positionierungsbohrungen 106 zugeordnet sind.

In einem bei gegenseitiger Ausrichtung der Grundplatte 20 und der Anschlußplatte 12 zum Raster der Führungskanäle 100 deckungsgleichen Raster sind in die Anschlußplatte 12 rohrförmige Gegenkontakte 108 für die Kontaktstifte 82 eingesetzt und jeweils über eine Verbindungsleitung 110 mit der nicht dargestellten elektronischen Einrichtung des Geräts verbunden, wobei jedem einzelnen Gegenkontakt 108 eine individuelle Adresse zugeordnet ist. Die oberen Enden der Gegenkontakte 100 sind auf der Oberfläche der Anschlußplatte 12 etwas umgebördelt, so daß sich bei einer axialen Bewegung der Kontaktstifte 82 in Richtung auf die Anschlußplatte 12 ein sicherer Kontakt zwischen den Kontaktspitzen 102 und den Gegenkontakten 108 ergeben kann.

Bei der Bestückung des Adapters 14 mit Kontaktstiften 82 entsprechend einer gegebenen Konfiguration der Anschlußbohrungen 84 auf der Leiterplatte 72 wird sich nicht notwendigerweise jeweils die gleiche Zuordnung der Kontaktstifte 82 zu den Gegenkontakten 108 ergeben. Dies hängt vielmehr davon ab, ob insbesondere bei manueller Nachhilfe bei der Ablenkung der nadelförmigen Abschnitte 92 die Ablenkung in der einen oder anderen Richtung erfolgt, wodurch es beispielsweise möglich ist, daß ein Kontaktstift, dessen Führungsachse genau in der Mitte zwischen vier benachbarten Führungskanälen 100 auftrifft, in einen beliebigen dieser vier Führungskanäle 100 eindringen kann. Es werden aber jeweils genau so viele Führungskanäle 100 und damit auch Gegenkontakte 108 einem Kontaktstift 82 zugeordnet sein, wie die Leiterplatte 72 Anschlußbohrungen 84 aufweist.

Vor dem Beginn der Leiterplattenprüfung wird anhand einer fehlerfreien Musterplatte die elektronische Einrichtung für die beabsichtigte Prüfung programmiert. Zu diesem Zweck wird die Musterleiterplatte auf die Auflagerzapfen 70 aufgelegt und dann mittels der Andrückvorrichtung 18 entgegen der Wirkung der Federn 76 gegen die Kontaktspitzen 98 gedrückt, wodurch zunächst aufgrund der federnden Anordnung der Kontaktspitzen ein sicherer Kontakt zwischen allen Aufnahmebohrungen 84 und den zugeordneten Kontaktspitzen 98 hergestellt wird. Bei Fortsetzung der Andrückbewegung gelangen sämtliche unteren Kontaktspitzen 102 in sicheren Kontakt mit den Gegenkontakten 108. Damit ist jeder durch eine Anschlußbohrung 84 bestimmte Anschlußpunkt der Leiterplatte mit der elektronischen Einrichtung der Vorrichtung verbunden. Diese wird nun in einen der Programmierung dienenden Schaltzustand versetzt, worauf nach einem Startsignal die elektronische Einrichtung alle möglichen Kombinationen der Zweipunktverbindungen auf der Musterleiterplatte in das Programm aufnimmt und jede Verbindung auf der Leiterplatte in ihren integrierten Speicher einspeichert. Nun kann die Musterleiterplatte wieder abgenommenn, die elektronische Einrichtung auf Betrieb umgeschaltet und eine beliebige Folge identischer Leiterplatten geprüft werden. Vom Gerät werden wieder alle möglichen Zweipunktverbindungen geprüft und die Prüfergebnisse mit der Speicherinformation verglichen. bei Identität läuft der Prüfvorgang weiter und es wird die nächste Kombination geprüft. Sofern aber die gemessenen und die gespeicherten Informationen nicht identisch sind, wird die Leiterplatte entsprechend nach Kurzschluß oder Unterbrechung aussortiert. Geeignete Anzeigeelemente können die Positionen anzeigen und diese können auch mittels eines Druckers in an sich bekannter Weise ausgedruckt werden. Gleichzeitig kann ein Fehlersignal, beispielsweise in Form einer Signallampe, betätigt werden.

Es ist aus der vorstehenden Beschreibung ersichtlich, daß der Adapter 14 insgesamt verhältnismäßig einfach aufgebaut ist und ebenso einfach den unterschiedlichen Konfigurationen der Anschlußpunkte an einer beliebigen Leiterplatte angepaßt werden kann. Der Adapter 14 läßt sich ohne weitere Maßnahmen höchst einfach von den Positionierungsstiften 104 abheben und durch einen einer anderen Leiterplatte zugeordneten Adapter ersetzen, der einfach auf diese Positionierungsstifte 104 aufgesetzt wird. Da die elektrische Verbindung zwischen dem Adapter 14 und der elektronischen Einrichtung des Geräts stets über den gleichen Kontaktraster der durch die Führungskanäle 100 im Raster positionierten Kontaktspitzen 102 einerseits und der Gegenkontakte 108 andererseits erfolgt, sind keinerlei weitere Verbindungsmaßnahmen, wie beispielsweise die Verbindung von Vielfachsteckern oder dergleichen erforderlich und die Vorrichtung gewinnt dadurch an technischer Zuverlässigkeit, Übersichtlichkeit der Anordnung und auch hinsichtlich ihres sachlichen und ästhetischen Erscheinungsbildes.

Da die Kontaktstifte 82 nach Entfernen der Sicherungsplatine 42 jederzeit entnommen werden können, besteht die Möglichkeit. diese Kontaktstifte 82 zur Bestückung unterschiedlicher Adapter 14 zu verwenden, was den Materialaufwand wesentlich herabsetzt. Von einem nicht mehr benötigten Adapter sind lediglich die beiden Führungsplatinen 30 und 32 und die Sicherungsplatine 42 verloren, weil deren Bohrungen mit den Anschlußbohrungen 84 der individuellen Leiterplatte deckungsgleich gebohrt sind. Das gesamte übrige Material kann jederzeit für die Anfertigung eines einer anderen Leiterplatte angepaßten Adapters verwendet werden.

## Ansprüche

1. Adapter zur Anpassung der rastergebundenen Konfiguration der Kontakte (108) einer elektronischen Prüfvorrichtung für Leiterplatten an die Konfiguration der nicht notwendig rastergebundenen Anschlußpunkte auf einer zu prüfenden Leiterplatte (72), mit einer Grundplatte (20), die in einem dichten Raster ausmündende, auf jeweils einen Kontakt der Prüfvorrichtung ausgerichtete Kanäle (100) besitzt, mit nadelartigen, jeweils einen dünnen Abschitt (92) und einen demgegenüber verstärkten Abschnitt (94) aufweisenden Kontaktstiften (82), die sich insgesamt jeweils von einem Anschlußpunkt der Leiterplatte durchgehend bis zu einem Kontakt der Prüfvorrichtung erstrecken, mit einer Positionierungsvorrichtung (80, 83) zur Ausrichtung der zu prüfenden Leiterplatte (72) gegenüber den Kontaktstiften mit einer weiteren Positionierungsvorrichtung (104, 106) zur Ausrichtung des Adapters gegenüber der Kontaktkonfiguration der Prüfvorrichtung, mit einer zur Grundplatte (20) parallel angeordneten Aufnahme (16) für die zu prüfende Leiterplatte (72), mit einer Andrückvorrichtung (18) zur Annäherung der an der Aufnahme (16) befindlichen Leiterplatte (72) an die Prüfstifte und mit einer in festem Abstand von der Grundplatte (20) angeordneten ersten Führungsplatine (32), die deckungsgleich zu den Anschlußpunkten der zu prüfenden Leiterplatte (72) angeordnete Borhungen (88) aufweist, in die die Kontaktstifte mit ihrem einen Ende (98) beweglich und gegen die Aufnahme (16) vorspringend eingesetzt sind, wobei die Kontaktstifte (82) in jeweils einen der kanäle (100) in der Grunkplatte (20) einmünden und mit ihren unteren Kontaktspitzen (102) elektrisch leitend an jeweils einem der Kontakte (108) der Prüfvorrichtung angreifen, dadurch gekennzeichnet,

– daß zwischen der Grundplatte (20) und der ersten Führungsplatine (32) von beiden beabstandet eine identisch zur ersten gebohrte weitere Führungsplatine (30) vorgesehen ist,

– daß jeweils der verstärkte Abschnitt (94) der Kontaktstifte die beiden Führungsplatinen (30, 32) annährend normal zu deren Ebenen durchquert und gegenüber dem dünnen Abschnitt (92) biegesteifer ist,

– daß jeweils der dünne Abschnitt (92) der Kontaktstifte von der weiteren Führungsplatine (30) beabstandet ist und sich bis su dem jeweiligen Kontakt (108) der Prüfvorrichtung erstreckt,

– daß jeweils das freie Ende des dünnen Abschnitts der Kontaktstifte zum Ausgleich von Fluchtungsfehlern zwischen den Anschlußpunkten der Leiterplatte (72) und den Kontakten (108) der Prüfvorrichtung seitlich elastisch auslenkbar ist,

– und daß der verstärkte Abschnitt (94) der Kontaktstifte (82) zur Begrenzung ihrer axialen Beweglichkeit nahe seinem oberen Ende mit einem Anschlag (96) versehen ist, der die axiale Bewegung des Kontaktstiftes (82) nach unten durch Anschlag an der Oberseite der Führungsplatine (32) begrenzen kann.

2. Adapter nach Anspruch 1, dadurch gekennzeichnet, daß der Anschlag (96) zwischen zwei benachbarten Platinen angeordnet ist.

3. Adapter nach Anspruch 2, dadurch gekennzeichnet, daß der Anschlag (96) auf der der Aufnahme (16) zugewandten Seite der am weitestens von der Grundplatte (20) entfernten Führungsplatine (32) angeordnet ist und daß mit Abstand von dieser Führungsplatine (32) zwischen ihr und der Aufnahme (16) eine mit dem Anschlag (96) zusammenwirkende Sicherungsplatine (42) angeordnet ist.

4. Adapter nach einem der vorhergehenden Ansprüche, dadurch gekennzeichnet, daß parallel zu den Kontakstiften (82) beweglich an den Führungsplatiner (30, 32) Auflager (70, 78) für die zu prüfende Leiterplatte (72) gelagert sind.

5. Adapter nach Anspruch 4, dadurch gekennzeichnet, daß die Auflager (70, 78) gegenüber den Führungsplatinen (30, 32) durch Rückstellfedern (76) abgestützt sind.

6. Adapter nach einem der Ansprüche 4 oder 5 dadurch gekennzeichnet, daß die Auflager durch Auflagerzapfen (70) gebildet werden, die in Führungsbohrungen (64, 66) der Führungsplatiner (30, 32) beweglich gelagert und mit einer Querschnittserweiterung (78) zur Abstützung der zu prüfenden Leiterplatte (72) versehen sind, wobei von der Querschnittserweiterung (78) gegen die Leiterplatte (72) ein Positionierungselement (80) vorspringt, welchem an der Leiterplatte (72) eine im Querschnitt angepaßte Ausnehmung (83) zugeordnet ist.

7. Adapter nach einem der vorhergehenden Ansprüche, dadurch gekennzeichnet, daß die Grundplatte (20), die Führungsplatinen (30, 32) und gegebenenfalls die Sicherungsplatine (42) durch die Distanzstücke (36, 38, 40) durchquerende Spannschrauben miteinander verdunden sind.

8. Adapter nach einem der vorhergehenden Ansprüche, dadurch gekennzeichnet, daß die Führungskanäle (100) in der Grundplatte (20) gegen die Führungsplatinen (30, 32) konisch erweitert sind.

9. Adapter nach einem der vornergehenden Ansprüche, dadurch gekennzeichnet, daß in die Grundplatte (20) Führungseinsätze (24) eingesetzt sind, in welchen die Führungskanäle (100) ausgebildet sind.

10. Adapter nach einem der vorhergehenden Ansprüche, dadurch gekennzeichnet, daß die Kontaktstifte (82) jeweils mit einer in ihrer Längsrichtung federelastisch gelagerten Kontaktspitze (98) versehen sind.

**Claims**

1. An adapter for adapting the grid-bound configuration of contacts (108) of an electronic testing device for printed circuit boards to the configuration of the not necessarily grid-bound connection points on a printed circuit board (72) which is to be tested, comprising a base plate (20) having ducts (100) opening into a dense grid and aligned with one contact of the testing device in each case, needlelike contact pins (82) each having a thin section (92) and thicker section (94) and extending as a whole from a connection point of the printed circuit board right through to a contact of the testing device, a positioning device (80, 83) for aligning the printed circuit board (72) to be tested with the contact pins (82), a second positioning device (104, 106) for aligning the adapter with the contact configuration of the testing device, a receiving element (16) arranged parallel to the base plate (20) for receiving the printed circuit board (72) to be tested, a pressing device (18) for pressing the printed circuit board (72) arranged on the receiving element (16) against the testing pins and a first guide plate (32), which is arranged a set distance from the base plate (20) and comprises bores (88) corresponding in position to the connection points of the printed circuit board (72) to be tested, into which bores (88) the contact pins are inserted with one end (98) movable and projecting towards the receiving element (16), the contact pins (82) leading in each case into one of the ducts (100) in the base plate (20) and acting electrically with their lower contact points (102) upon one of the contacts (108) of the testing device in each case, characterised in that

– provided between the base plate (20) and the first guide plate (32) and at a distance from both plates is a second guide plate (30) which comprises identical bores to the first guide plate,

– the thicker section (94) of the contact pins passes through the two guide plates (30, 32) approximately at right angles to their planes in each case and is more rigid than the thin section (92),

– the thin section (92) of the contact pins is arranged at a distance from the second guide plate (30) and extends as far as the respective contact (108) of the testing device,

– the free end of the thin section of the contact pins can be deflected laterally in a resilient manner in order to compensate for alignment errors between the connection points of the printed circuit board (72) and the contacts (108) of the testing device,

– and the thicker section (94) of the contact pins (82) is provided in the region of its upper end to limit its axial movement with an abutment (96), which can restrict the axial movement of the contact pin (82) downwards by abutting against the upper face of the guide plate (32).

2. An adapter according to claim 1, characterised in that the abutment (96) is arranged between two adjacent plates.

3. An adapter according to claim 2, characterised in that the abutment (96) is arranged on the side facing the receiving element (16) of the guide plate (32) farthest from the base plate (20) and a safety plate (42) cooperating with the abutment (96) is arranged at a distance from said guide plate (32) between the latter and the receiving element (16).

4. An adapter according to one of the preceding claims, characterized in that supports (70, 78) for the printed circuits boards (72) to be tested are mounted parallel to the contact pins (82) so as to be movable along the guide plates (30, 32).

5. An adapter according to claim 4, characterised in that the supports (70, 78) are supported relative to the guide plates (30, 32) by restoring springs (76).

6. An adapter according to one of claims 4 or 5, characterised in that the supports are formed by bearing journals (70), which are displaceably mounted in guide bores (64, 66) in the guide plates (30, 32) and are provided with a cross sectional enlargement (78) for supporting the printed boards boards (72) to be tested, a positioning element (80) projecting from the cross sectional enlargment (78) towards the printed circuit board (72) and being associated with a recess (83) in the printed circuit board (72) matching the positioning element in its cross section.

7. An adapter according to one of the preceding claims, characterised in that the base plate (20), the guide plates (30, 32) and optionally the safety plate (42) are connected with one another by tensioning screws passing through the spacing elements (36, 38, 40).

8. An adapter according to one of the preceding claims, characterised in that the guide ducts (100) in the base plate (20) are conically enlarged in the direction of the guide plates (30, 32).

9. An adapter according to one of the preceding claims, characterised in that guide inserts (24), in which the guide ducts (100) are formed, are inserted in the base plate (20).

10. An adapter according to one of the preceding claims, characterised in that the contact pins (82) are provided in each case with a contact point (98) mounted so as to be resilient in its longitudinal direction.

## Revendications

1. Adaptateur pour l'adaptation de la configuration, qui est liée à une trame, des contacts (108) d'un dispositif de contrôle électronique de plaquettes à circuit imprimé à la configuration des points de connexion, qui ne sont pas nécessairement liés à la trame, d'une plaquette à circuit imprimé à examiner (72), comprenant une plaque de base (20) qui possède des canaux (100) débouchant en une trame dense et alignés sur chaque fois l'un des contacts du dispositif de contrôle, des tiges de contact (82) en forme d'aiguilles qui présentent un tronçon mince (92) et un tronçon renforcé par rapport à celui-ci (94) et qui s'étendent chacune de manière continue jusqu'à un contact du dispositif de contrôle depuis un point de connexion de la plaquette à circuit imprimé, un dispositif de positionnement (80, 83) pour l'alignement de la plaquette à circuit imprimé (72) à examiner par rapport aux tiges de contact et un autre dispositif de positionnement (104, 106) pour l'alignement de l'adaptateur par rapport à la configuration des contacts du dispositif de contrôle, un élément de réception (16), agencé parallèlement à la plaque de base (20), pour la plaquette a circuit imprimé (72) à examiner, un dispositif presseur (18) destiné à rapprocher la plaquette à circuit imprimé (72), située sur l'élément de réception (16), des contacts de contrôle et une première platine de guidage (32) qui est agencée à distance fixe de la plaque de base (20), et qui présente des perforations (88) qui sont agencées de manière à coïncider avec les points de connexion de la plaquette à circuit imprimé (72) à examiner et dans laquelle les tiges de contact sont introduites avec l'une de leurs extrémités (98) déplaçable et de façon à faire saillie vers l'élément de réception (16), les tiges de contact (82) débouchant chaque fois dans l'un des canaux (100) dans la plaque de base (20), et agissant sur chaque fois l'un des contacts (108) du dispositif de contrôle de manière électriquement conductrice par leurs pointes de contact inférieures (102), caractérisé en ce que :

– il est prévu, entre la plaque de base (20) et la première platine de guidage (32), une autre platine de guidage perforée (30), qui est espacée par rapport à chacune de celles-ci et qui est identique à la première,

– en ce que chaque fois le tronçon renforcé (94) des tiges de contact traverse les deux platines de guidage (30, 32) approximativement d'une manière normale au plan de ces platines et que celui-ci est plus résistant à la flexion que le tronçon mince (92),

– en ce que le tronçon mince (92) des tiges de contact est chaque fois espacé de l'autre platine de guidage (30) et qu'il s'étend jusqu'au contact respectif (108) du dispositif de contrôle,

– en ce que l'extrémité libre du tronçon mince des tiges de contact peut être déviée élastiquement latéralement pour compenser des erreurs d'alignement entre les points de connexion de la plaquette à circuit imprimé et les contacts (108) du dispositif de contrôle, et

– en ce que le tronçon renforcé des tiges de contact (82) est pourvu d'une butée (96) pour la limitation de leur possibilité de déplacement axial à proximité de son extrémité supérieure, ladite butée pouvant limiter le déplacement axial de la tige de contact (82) vers le bas par arrêt au côté supérieur de la platine de guidage (32).

2. Adaptateur suivant la revendication 1, caractérisé en ce que la butée (96) est agencée entre deux platines voisines.

3. Adaptateur suivant la revendication 2, caractérisé en ce que la butée (96) est agencée du côté orienté vers l'élément de réception (16) de la platine de guidage (32) qui est la plus éloignée de la plaque de base (20) et en ce qu'une platine de sécurité (42) coopérant avec la butée (96) est agencée à distance de cette platine de guidage (32), entre elle et l'élément de réception (16).

4. Adaptateur suivant l'une des revendications précédentes, caractérisé en ce que des supports (70, 78) pour la plaquette à circuits imprimés à examiner (72) sont supportés sur les platines de guidage (30, 32), de manière à pouvoir être déplacés parallèlement aux tiges de contact (82).

5. Adaptateur suivant la revendication 4, caractérisé en ce que les supports (70, 78) sont soutenus par rapport aux platines de guidage (30, 32) par des ressorts de rappel (76).

6. Adaptateur suivant l'une des revendications 4 et 5, caractérisé en ce que les supports sont formés par des goupilles de support (70) qui sont supportées de manière déplaçable dans des perforations de guidage (64, 66) des platines de guidage (30, 32) et qui sont pourvues d'un élargissement en section transversale (78) pour le support de la plaquette à circuit imprimé (72) à examiner, un élément de positionnement (80) faisant saillie à partir de l'élargissement en section transversale (78) vers la plaquette à circuit imprimé (72), un évidement (83) adapté en section transversale étant adjoint à cet élément de positionnement sur la plaquette à circuit imprimé (72).

7. Adaptateur suivant la revendication 6, caractérisé en ce que la plaque de base (20), les platines de guidage (30, 32) et éventuellement la platine de sécurité (42) sont mutuellement reliées par des vis de serrage qui passent à travers les pièces d'écartement (36, 38, 40).

8. Adaptateur suivant l'une des revendications précédentes, caractérisé en ce que les canaux de guidage (100) sont évasés de manière conique dans la plaque de base (20) en direction des platines de guidage (30, 32).

9. Adaptateur suivant l'une des revendications précédentes, caractérisé en ce que, dans la plaque de base (20), sont introduits des éléments insérés de guidage (24) dans lesquels les canaux de guidage (100) sont façonnés.

10. Adaptateur suivant l'une des revendications précédentes, caractérisé en ce que les tiges de contact (82) sont chacune pourvues d'une pointe de contact (98) qui est supportée de manière élastique dans sa direction longitudinale.

FIG.1

FIG.2

FIG.3